# EUROPÄISCHE PATENTANMELDUNG

(11) **EP 0 609 695 A1**
(43) Veröffentlichungstag der Anmeldung: **10.08.1994**
(21) Anmeldenummer: 94100689.2
(22) Anmeldetag: 19.01.1994
(51) Int. Cl.: C23C 14/16

(54) **Korrosionsschutzüberzug für Aluminium-Werkstoffe**

(30) Priorität: 05.02.1993 DE 4303312
(71) Anmelder: DORNIER LUFTFAHRT GmbH, D-88039 Friedrichshafen (DE)
(72) Erfinder: Holbein, Reinhold, Dr., D-88677 Markdorf (DE); Dembek, Antje, D-88090 Immenstaad (DE)

(57) **Zusammenfassung**

Die Erfindung betrifft einen Korrosions-Schutzüberzug für Aluminium-Werkstoffe, der eine Schicht aus Aluminium oder aus einer Al-Legierung umfaßt.

## Beschreibung

Die Erfindung betrifft einen Korrosionsschutzüberzug für Aluminium-Werkstoffe.

Im Flugzeugbau werden als Korrosionsschutzschichten bei Aluminium anodisch erzeugte Oxidschichten eingesetzt. Diese Oxidschichten haben jedoch den Nachteil, daß sie die Ermüdungseigenschatten der Grundwerkstoffe herabsetzen. Desweiteren werden bei der Herstellung, insbesondere durch eine anodische Oxidation mittels des Chromsäureverfahrens, umweltbelastende Abwässer in großer Menge erzeugt.

Der Erfindung liegt deshalb die Aufgabe zugrunde, einen Korrosions-Schutzüberzug für Aluminium-Werkstoffe zu schaffen, mit dem die Ermüdungseigenschaften des Grundwerkstoffs möglichst wenig herabgesetzt wegen.

Diese Aufgabe wird mit einem Schutzüberzug nach Anspruch 1 gelöst. Besondere Ausgestaltungen der Erfindung sind Gegenstand weiterer Ansprüche.

Erfindungsgemäß umfaßt der Schutzüberzug eine Schicht aus Reinaluminium (≦99,9) oder einer Al-Legierung. Besonders vorteilhaft sind dabei AlSi-Legierungen, z.B. mit einem Si-Gehalt von 2 bis 4 Gew.% Si.
Weitere bevorzugte Al-Legierungen sind z.B.:
AlZn(Mg) mit ca. 4 bis 5 Gew.% Zn und max. 3 Gew.% Mg,
AlLi mit 2 bis 3 Gew.% Li.
Die Schichtdicken werden in bevorzugten Ausführungsformen im Bereich zwischen 8 bis 15 µm gewählt.

Der Schutzüberzug eignet sich für Aluminium und Aluminium-Legierungen. Besonders geeignet ist er als Schutzüberzug für folgende Aluminiumwerkstoffe:
3.1354 (Al 4,4Cu 1,5Mg 0,6Mn);
3.4364 (Al 5,6Zn 2,5Mg 1,6Cu 0,23Cr);
3.4384 (Al 5,6Zn 2,5Mg 1,6Cu 0,23Cr).
Der Werkstoff 3.4384 weist gegenüber dem Werkstoff 3.4364 einen höheren Reinheitsgrad auf.

Bei Verschleißbeanspruchung kann auf die erfindungsgemäße Korrosionsschutzschicht eine zusätzliche Schicht aus einer AlN -Legierung oder einer CrN-Legierung als obere Lage aufgebracht werden. Damit kann die Reibcharakeristik (Reibkorrosion, Reibwertkonstanz und Reibwerthöhe, Gleit- und Adhäsionsverschleiß) bei tribologischer Beanspruchung verbessert werden. Es können auch andere reibwertmindernde Reaktionsschichten auf Aluminiumbasis verwendet werden.
Die Dicke der tribologischen Schutzschicht liegt bevorzugt bei 3 bis 7 µm.

Die Erfindung eignet sich insbesondere zum Schutz von Bauteilen für Luftfahrtanwendungen. Sie eignet sich auch zur Plattierung von komplex geformten Frässtrukturen in Kombination mit einer anschließenden Anodisation. Hierdurch wird eine deutliche Erhöhung der Kotrosionsresistenz von bislang nicht plattierbaren Fräsbauteilen ermöglicht.

Der erfindungsgemäßen Schutzschichten besitzen folgende vorteilhaften Eigenschaften:
- sie bieten kathodischen Schutz des Grundwerkstoffs;
- sie sind elektrisch leitend und deshalb unproblematisch bei erforderlichen Masseanschlüssen;
- sie verursachen eine geringere Reduktion der Ermüdungseigenschaften verglichen mit Oxidschichten, die mittels der Chromsäureanodisation hergestellt wurden;
- der Anfall umweltbelastende Abwässer wird gegenüber der Anwendung der Chromsäureanodisation vermindert
- sie bilden einen geeigneten Haftgrund für handelsübliche organische Beschichtungssysteme.

Vorteilhaft werden die Schichten (Korrosionsschutzschicht und tribologische Schutzschicht) durch PVD-Beschichtungsverfahren (PVD = Physical Vapour Deposition) aufgebracht. Die Beschichtung erfolgt dabei in einem Vakuumrezipienten.
Durch die Anwendung dieses Verfahrens sind geringe Schichtdicken bei verbesserter Schichtqualität (Dichtheit, Schichtdickenkonstanz, homogene Atomverteilung der Legierungspartner über die gesamte Schichtdicke) und Haftfestigkeit möglich. Insbesondere ist auch die Beschichtung von kompliziert geformten Bauteilen, z.B. Frästeilen, möglich.

Die folgenden PVD-Verfahren eigenen sich besonders zur Aufbringung der Schichten:
Bedampfen: Beim Bedampfen wird das Beschichtungsmaterial durch Erwärmung verdampft und kondensiert auf dem zu beschichtenden Bauteil.

Besputtern: Das Beschichtungsmaterial wird durch den Impulsübertrag auftreffender Ar-Ionen freigesetzt und kondensiert auf dem zu beschichtenden Bauteil. Durch die hohe kinetische Energie und Dichte der Beschichtungspartikel wird eine geringere Porosität und höhere Haftfestigkeit der Beschichtung sowie eine hohe Beschichtungsrate erreicht.

Eine weiter gesteigerte Dichte und Haftfestigkeit der Beschichtung ist mit dem Ionenoplattierverfahren möglich: Bei diesem Verfahren wird ein Teil des Beschichtungsmaterials in den Grundwerkstoff implantiert. Hier können insbesondere das IBAD (Ion Beam Assisted Deposition)-Verfahren und das Arc-Verfahren vorteilhaft angewendet werden.

Beim IABD-Verfahren wird das Beschichtungsmaterial in einem Elektronenstrahlspot, beim Arc-Verfahren in einem Lichtbogenspot freigesetzt. Nach der Ionisierung und Beschleunigung gelangt es mit ebenfalls beschleunigten Ar-Ionen auf den Grundwerkstoff. Diese mischen den Beschichtungswerkstoff zu Beginn der Beschichtung zum Teil in den phasengrenznahen Bereich des Grundwerkstoffs ein. Dabei wird ein definierter Eigenspannungszustand angestrebt. Das Auflegieren des phasengrenznahen Bereichs und das Einstellen des Eigenspannungszustandes erhöht die Haftfestigkeit der nachfolgend aufgebauten Beschichtung und erhöht die Fehlstellenhäufigkeit.

Mittels Arc-Verfahren aufgebrachte AlSi-Schichten erwiesen sich sowohl im Salzsprühnebeltest (DIN 50021) und im lackierten Zustand im VDA Test den konventionellen Oxidschichten gleichwertig oder überlegen. Messungen der Ermüdungseigenschaften an ungekerbten Proben im Dauerschwingungsversuch mit R = 0,1 und F = 25 Hz zeigten nicht den nach anodischer Oxidation charakteristischen Abfall.

## Patentansprüche

1. Korrosions-Schutzüberzug für Aluminium-Werkstoffe, **dadurch gekennzeichnet,** daß er eine Schicht aus Aluminium oder aus einer Al-Legierung umfaßt.

2. Korrosions-Schutzüberzug für Aluminium-Werkstoffe nach Anspruch 1, **dadurch gekennzeichnet,** daß die Al-Legierung eine AlSi-Legierung ist.

3. Korrosions-Schutzüberzug für Aluminium-Werkstoffe nach Anspruch 2, **dadurch gekennzeichnet,** daß die AlSi-Legierung 2 bis 4 Gew % Si enthält.

4. Korrosions-Schutzüberzug für Aluminium-Werkstoff nach Anspruch 1, **dadurch gekennzeichnet,** daß die Al-Legierung eine AlLi-Legierung mit 2 bis 3 Gew.% Li ist.

5. Korrosions-Schutzüberzug für Aluminium-Werkstoffe nach Anspruch 1, **dadurch gekennzeichnet,** daß die Al-Legierung eine AlZn(Mg)-Legierung mit 4 bis 5 Gew.% Zn und bis zu 3 Gew.% Mg ist.

6. Korrosions-Schutzüberzug nach einem der vorangehenden Ansprüche, **dadurch gekennzeichnet,** daß zusätzlich eine Schicht aus einer AlN-Legierung oder einer CrN-Legierung zur Verbesserung der Reibcharakteristik bei tribologischer Beanspruchung vorhanden ist.
